Europäisches Patentamt

European Patent Office

Office européen des brevets

(11) Veröffentlichungsnummer: **0 252 301**
**A1**

## (12) EUROPÄISCHE PATENTANMELDUNG

(21) Anmeldenummer: 87108113.9

(22) Anmeldetag: 04.06.87

(51) Int. Cl.⁴: **G01R 31/28 , G01R 31/02**

(30) Priorität: **30.06.86 DE 3621841**

(43) Veröffentlichungstag der Anmeldung:
**13.01.88 Patentblatt 88/02**

(84) Benannte Vertragsstaaten:
**AT BE CH DE FR GB IT LI NL**

(71) Anmelder: **Siemens Aktiengesellschaft Berlin und München**
**Wittelsbacherplatz 2**
**D-8000 München 2(DE)**

(72) Erfinder: **Seinecke, Siegfried, Dr. Ing.**
**Kiem-Pauli-Weg 3**
**D-8130 Starnberg-Söcking(DE)**

(54) **Verfahren zum Lokalisieren von fehlerhaften Verbindungen zwischen Leiterbahnen und/oder Spannungsebenen von Mehrlagenleiterplatten.**

(57) Zum Lokalisieren von fehlerhaften Verbindungen zwischen Leiterbahnen und/oder Spannungsebenen von Mehrlagenleiterplatten wird an die fehlerhaft verbundenen Ebenen (2,3) der ·Leiterplatte (1) eine Spannung (6) angelegt und an verschiedenen Punkten der Ebenen (2,3) die Differenzspannung (8) zwischen ihnen gemessen.

FIG 1

EP 0 252 301 A1

## Verfahren zum Lokalisieren von fehlerhaften Verbindungen zwischen Leiterbahnen und/oder Spannungsebenen von Mehrlagenleiterplatten

Mehrlagenleiterplatten können, insbesondere in der Entwicklungsphase einer neuen Einbautechnik, mehr oder weniger niederohmige Verbindungen zwischen Leiterbahnen verschiedener Lagen bzw. zwischen verschiedenen Spannungsebenen aufweisen. Solche fehlerhafte Verbindungen treten in der Regel an Durchkontaktierungen zwischen den verschiedenen Lagen der Leiterplatten auf. Um derartige, in der Regel sehr teuere Leiterplatten reparieren zu können, muß zunächst diejenige Stelle gefunden werden, an der die fehlerhafte Verbindung besteht, um sie später z.B. durch Ausbohren beseitigen zu können. Manchmal treten sogar mehrere Fehler dieser Art gleichzeitig in einund derselben Leiterplatte auf.

Der Erfindung lag daher die Aufgabe zugrunde, ein Verfahren zu schaffen, mit dem schnell und ohne Beschädigung der Leiterplatte fehlerhafte Verbindungen zwischen Leiterbahnen und/oder Spannungsebenen von Mehrlagenleiterplatten lokalisiert werden können.

Diese Aufgabe wird erfindungsgemäß dadurch gelöst, daß an die fehlerhaft miteinander verbundenen Ebenen der Leiterplatte eine Spannung angelegt und an verschiedenen Punkten der Ebenen die Differenzspannung zwischen ihnen festgestellt wird.

Weitere Einzelheiten der Erfindung ergeben sich aus der Beschreibung der Erfindung anhand der FIG 1 bis 3, wobei

FIG 1 die Anwendung eines strom-und spannungsbegrenzten Gleichstromgenerators als Spannungsquelle,

FIG 2 die Tastung der Spannungsquelle und Triggerung des Meßgerätes und

FIG 3 die Verwendung eines frequenzstabilen Sinusgenerators als Spannungsquelle und eines selektiven, schmalbandigen Wechselspannungsvoltmeters als Meßgerät zeigt.

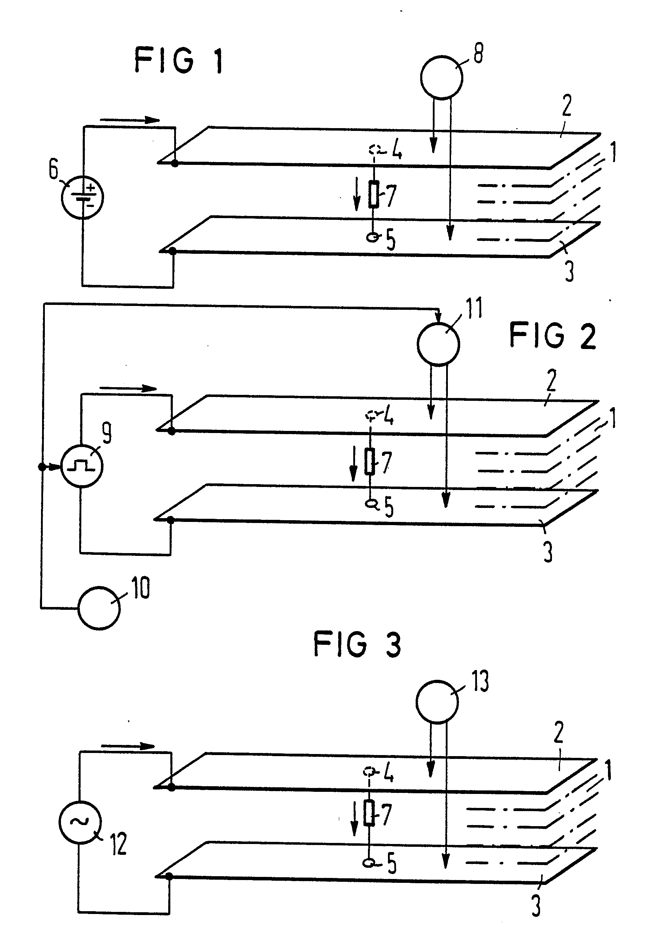

Die FIG 1 zeigt in schematischer Darstellung eine Mehrlagenleiterplatte 1 mit zwei Ebenen 2 und 3 - z.B. verschiedenen Spannungsebenen - , die an den Punkten 4 und 5 fehlerhaft miteinander verbunden sein sollen. Derartige fehlerhafte Verbindungen zwischen verschiedenen Ebenen einer Mehrlagenleiterplatte sind in der Regel von außen nicht sichtbar. Um die Stelle einer solchen fehlerhaften Verbindung dennoch lokalisieren zu können, wird erfindungsgemäß an die fehlerhaft miteinander verbundenen Ebenen 2 bzw. 3 der Leiterplatte 1 eine Spannung angelegt. Im Beispiel von FIG 1 dient dazu ein Gleichstromgenerator 6. Dieser ist vorzugsweise als strombegrenztes und spannungsbegrenztes Netzgerät ausgebildet und wird so eingestellt, daß die Wärmeleistung an dem Innenwiderstand 7 der fehlerhaften Verbindung zwischen den Punkten 4 und 5 zwar zur lokalen Erwärmung, nicht jedoch zum Brennen oder Verkohlen der Verbindung führt. Ferner wird mit Hilfe eines empfindlichen Meßinstrumentes 8 an verschiedenen Punkten der beiden Ebenen 2 und 3 die Differenzspannung zwischen ihnen festgestellt. Diese Differenzspannung wird entweder an neben einanderliegenden Durchkontaktierungen der Leiterplatte 1 oder aber an verschiedenen Punkten der einen Ebene 2 bzw. 3 einerseits und dem Einspeisepunkt der Spannung an der anderen Ebene andererseits gemessen. Die mit diesem empfindlichen Meßinstrument 8 gemessene Differenzspannung zwischen den beiden Ebenen hat ein Minimum am Ort der fehlerhaften Verbindung, hier den beiden Punkten 4 und 5.

Um bei gleicher Empfindlichkeit der Messungen die Wärmeerzeugung an dem Innenwiderstand 7 der fehlerhaften Verbindung zwischen den beiden Punkten 4 und 5 erheblich einzuschränken, kann es gemäß dem Ausführungsbeispiel nach FIG 2 vorteilhaft sein, als Spannungsquelle einen Generator 9 vorzusehen, der bei gleichen maximalen Strom jedoch kurzzeitig mit Hilfe eines Tastgenerators 10 aufgetastet wird. Ferner sollte dann das Meßinstrument 11 zusammen mit dem Generator 9 von dem Tastgenerator 10 getriggert werden.

Tastet man z.B. den Generator 9 für 10 msec auf und wählt eine Pause von 990 msec, so ist die Erwärmung der fehlerhaften Verbindung zwischen den Punkten 4 und 5 um den Faktor 100 reduziert und je Sekunde kann ein Meßwert aufgenommen werden. Man kann aber auch mit höheren Strömen arbeiten und damit eine entsprechend höhere Auflösung erreichen und dennoch immer noch eine wesentlich geringere Wärmeleistung gegenüber der stationären Gleichstrommessung haben.

Gemäß dem Ausführungsbeispiel von FIG 3 ist es auch möglich, als Spannungsquelle einen frequenzstabilen Sinusgenerator 12 vorzusehen und als Meßinstrument 13 ein selektives, - schmalbandiges Wechselspannungsvoltmeter einzusetzen. Ein solches Voltmeter hat naturgemäß eine um etwa eine Zehnerpotenz höhere Empfindlichkeit und es ist damit möglich, bei gleicher Auflösung einen entsprechend kleineren Strom als bei einer stationären Gleichstrommessung zu nehmen.

Zur Beschleunigung der Lokalisierung solcher fehlerhafter Verbindungen in Mehrlagenleiterplatten können in Weiterbildung des allgemeinen Erfindungsgedankens folgende Maßnahmen vorteilhaft eingesetzt werden:

Die Speisespannungen der Generatoren 6, 9 und 12 aus den FIG 1, 2 und 3 werden vorzugsweise über eine Einspannvorrichtung am gesamten Rand der Leiterplatte eingespeist. Dadurch erreicht man eine besonders niederohmige Einspeisung und der Plattenrand der zu prüfenden Leiterplatte stellt jeweils eine Äquvipotentiallinie dar.

Alle in Betracht zu ziehenden Durchkontaktierungen der Leiterplatte werden mit Hilfe einer robotergeführten Sonde abgetastet und das dort herrschende Potential jeweils gemessen.

Wenn man alle festgestellten Meßwerte der abgetasteten Punkte einer Leiterplatte speichert und am Ende der Mesungen mit Hilfe einer Datenverarbeitunganlage ein dreidimensionales Potentialgebirge der Leiterplatte aufzeichnet, lassen sich bei Leiterplatten mit sehr vielen Abtastpunkten und damit der Möglichkeit von vielen fehlerhaften Verbindungen zwischen ihren Ebenen rasch ein Überblick und die Möglichkeit der baldigen Behebung der Fehler erreichen.

**Ansprüche**

1. Verfahren zum Lokalisieren von fehlerhaften Verbindungen zwischen Leiterbahnen bzw. Spannungsebenen von Mehrlagen-Leiterplatten, **dadurch gekennzeichnet,** daß an die fehlerhaft miteinander verbundenen Ebenen (2,3) der Leiterplatte (1) eine Spannung (6) angelegt und an verschiedenen Punkten der Ebenen (2,3) die Differenzspannung (8) zwischen ihnen festgestellt wird.

2. Verfahren nach Anmspruch 1, **dadurch gekennzeichnet,** daß die Differenzspannung (8) jeweils an nebeneinanderliegenden Durchkontaktierungen der Leiterplatte (1) gemessen wird.

3. Verfahren nach Anspruch 1, **dadurch gekennzeichnet,** daß die Differenzspannung jeweils zwischen verschiedenen Punkten der einen Ebene der Leiterplatte und dem Einspeisepunkt der Spannung an der anderen Ebene gemessen wird.

4. Verfahren nach einem der Ansprüche 1 bis 3, **dadurch gekennzeichnet,** daß die Spannung vorzugsweise über eine Einspannvorrichtung, am gesamten Rand der Leiterplatte niederohmig eingespeist wird.

5. Verfahren nach einem der Ansprüche 1 bis 4, **dadurch gekennzeichnet,** daß alle in betracht zu ziehenden Durchkontaktierungen der Leiterplatte mit Hilfe einer robotergeführten Sonde abgetastet und das dort herrschende Potential gemessen wird.

6. Verfahren nach einem der Ansprüche 1 bis 5, **dadurch gekennzeichnet,** daß alle festgestellten Meßwerte gespeichert und am Ende der Messungen mit Hilfe einer Datenverarbeitungsanlage ein dreidimensionales Potentialgebirge der Leiterplatte aufgezeichnet wird.

7. Verfahren nach einem der vorhergehenden Ansprüche, **dadurch gekennzeichnet,** daß als Spannungsquelle ein Strom-und spannungsbegrenzter Gleichstromgenerator (6) vorgesehen ist.

8. Verfahren nach Anspruch 7, **dadurch gekennzeichnet,** daß der Generator (9) nur jeweils kurzzeitig aufgetastet (10) und das Differenzspannungs-Meßgerät (11) jeweils nur zur Erfassung des Meßwertes getriggert wird.

9. Verfahren nach einem der vorhergehenden Ansprüche, **dadurch gekennzeichnet,** daß als Spannungsquelle ein frequenzstabiler Sinusgenerator (12) und als Meßerät ein selektives, schmalbandiges Wechselspannungs-Voltmeter (13) vorgesehen ist.

FIG 1

FIG 2

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | IBM TECHNICAL DISCLOSURE BULLETIN, Band 20, Nr. 7, Dezember 1977, Seiten 2627-2729, New York, US; K.J. DESKUR: "Short circuit detection" * Seite 2627, Zeile 1 - Seite 2628, Zeile 5; Figur A * | 1,2,5, 6 | G 01 R 31/28 G 01 R 31/02 |
| Y | US-A-3 763 430 (C.H. TERREY) * Spalte 1, Zeilen 34-49; Spalte 4, Zeilen 40-47; Spalte 4, Zeile 63 - Spalte 5, Zeile 9; Spalte 13, Zeilen 11-16; Spalte 16, Zeilen 33-38; Figuren 1,4 * | 1,2,5, 6 | |
| A | ELECTRONICS, Band 49, Nr. 19, 16. September 1976, Seiten 118-119; R.A. ROSNER: "DVM locates short circuit on wired circuit board" * Insgesamt * | 1,4-6 | **RECHERCHIERTE SACHGEBIETE (Int. Cl.4)** G 01 R H 05 K |
| A | PATENT ABSTRACTS OF JAPAN, Band 7, Nr. 282 (P-243)[1427], 16. Dezember 1983; & JP-A-58 158 564 (NIPPON DENKI K.K.) 20-09-1983 | 3 | |
| A | US-A-3 992 663 (P. SEDDICK) * Spalte 3, Zeilen 22-24; Figur 1 * | 8,9 | |

Der vorliegende Recherchenbericht wurde für alle Patentansprüche erstellt.

| Recherchenort | Abschlußdatum der Recherche | Prüfer |
|---|---|---|
| DEN HAAG | 09-10-1987 | PENZKOFER, B. |